# EUROPÄISCHE PATENTANMELDUNG

(11) **EP 1 748 558 A1**
(43) Veröffentlichungstag der Anmeldung: **31.01.2007**
(21) Anmeldenummer: 06117585.7
(22) Anmeldetag: 20.07.2006
(51) Int. Cl.: H03J 1/00

(54) **Rundfunkempfangseinheit**

(30) Priorität: 27.07.2005 DE 102005035093
(71) Anmelder: ROBERT BOSCH GMBH, 70442 Stuttgart (DE)
(72) Erfinder: Wittig, Rainer, 31249, Hohenhameln (DE); Arnold, Rainer, 31079, Sibbesse (DE); Passoke, Jens, 30966, Hemmingen (DE)

(57) **Zusammenfassung**

Bei einer Rundfunkempfangseinheit (1) mit einem Mischer (4) zum Heruntermischen eines hochfrequenten Empfangssignals (HP) auf eine Zwischenfrequenz (ZF) und mit einem mit dem Mischer (4) verbundenen Frequenzgenerator (7) mit einer Phasenregel- und Phasenrastschaltung, die einen spannungsgesteuerten Oszillator (8), einen mit dem Ausgang des spannungsgesteuerten Oszillators (8) direkt oder indirekt verbundenen Phasenvergleicher (10) zum Vergleichen eines zum Ausgangssignal des spannungsgesteuerten Oszillators (8) proportionalen Signals mit einem Referenzsignal (r_{ref}) und einen Schleifenfilter (11) am Ausgang des Phasenvergleichers (10) hat, ist der Ausgang des Schleifenfilters (11) mit dem spannungsgesteuerten Oszillator (8) verbunden ist und das Schleifenfilter (11) durch Einstellen eines Schleifenfilterstroms (Iₛ) mit einer Steuerungseinheit (12) einstellbar.

Die Steuerungseinheit (12) ist zur Hochschaltung des Schleifenfilterstroms (Iₛ) auf einen im Vergleich zum eingestellten Stromwert für den Empfang einer Empfangsfrequenz erhöhten Stromwert zur Durchführung eines Tests von alternativen Empfangsfrequenzen (AF-Tests) und Beibehaltung des erhöhten Stromwertes während des AF-Tests und Herunterschaltung des Schleifenfilterstroms (Iₛ) auf den reduzierten Stromwert zum Empfangen einer Empfangsfrequenz nach Abschluss des AF-Tests ausgebildet.

## Beschreibung

Die Erfindung betrifft eine Rundfunkempfangseinheit mit einem Mischer zum Heruntermischen eines hochfrequenten Empfangssignals auf eine Zwischenfrequenz und mit einem mit dem Mischer verbundenen Frequenzgenerator mit einer Phasenregel- und Phasenrastschaltung, die einen spannungsgesteuerten Oszillator, einen mit dem spannungsgesteuerten Oszillator direkt oder indirekt verbundenen Phasenvergleicher zum Vergleichen eines zum Ausgangssignal des spannungsgesteuerten Oszillators proportionalen Signals mit einem Referenzsignal und einen Schleifenfilter am Ausgang des Phasenvergleichers hat, wobei der Ausgang des Schleifenfilters mit dem spannungsgesteuerten Oszillator verbunden ist und der Schleifenfilter durch Einstellen eines Schleifenfilterstroms mit einer Steuerungseinheit einstellbar ist.

Rundfunkempfänger bieten oftmals die Möglichkeit, bei schlechter Signalqualität die gleiche Modulation auf alternativen Frequenzen zu empfangen. Eine solche Funktion ist insbesondere mit Hilfe des sogenannten Radio-Daten-Service (RDS) in Rundfunkempfängern für den mobilen FM Empfang, insbesondere in Autoradios implementiert. Vor dem Umschalten des Empfangs und der Audiowiedergabe auf eine der alternativ zur Verfügung stehenden Frequenzen stellen die Empfänger zunächst sicher, dass bei den Alternativfrequenzen eine entsprechend bessere Signalqualität vorliegt. Zu diesem Zweck springt der Empfänger bei Geräten mit nur einem Tuner auf diese alternative Frequenz und testet hier unter anderem die Signalqualität. Damit diese sogenannten Alternativ-Frequenz-Tests möglichst geringe Störungen in der Audiowiedergabe verursachen, wird die durch den AF-Test erzeugte Störung verschleiert. Hierzu kann zum Beispiel die Audiowiedergabe gemutet oder ein künstlich generiertes Signal einblendet werden. Um den Störeindruck im Audiosignal gering zu halten, wird angestrebt, die Zeitspanne der Störung so kurz wie möglich zu gestalten. Diese Zeitspanne wird wiederum durch die erforderliche Einschwingzeit der Phasenregel- und Phasenrastschaltung (Phase Locked Loop-PLL) des Frequenzgenerators, die zur Verfügung stehende Testzeit auf der alternativen Frequenz und die Länge des AF-Tests bestimmt. Somit ist ein Kompromiss zwischen der Störung im Audiosignal und der Qualität der Vorhersage der Signalqualität auf der alternativen Frequenz zu finden.
Aufgabe der vorliegenden Erfmdung ist es daher, eine verbesserte Rundfunkempfangseinheit zu schaffen, mit der Alternativ-Frequenz-Tests möglichst unhörbar, d.h. mit geringstmöglicher Störung im Audiosignal durchgeführt werden können.

Die Aufgabe wird mit der gattungsgemäßen Rundfunkempfangseinheit dadurch gelöst, dass die Steuerungseinheit zur Hochschaltung des Schleifenfilterstroms auf einen im Vergleich zum eingestellten Stromwert für den Empfang einer Empfangsfrequenz erhöhten Stromwert zur Durchführung eines Tests von alternativen Empfangsfrequenzen und Beibehaltung des erhöhten Stromwertes während des AF-Tests und Herunterschaltung des Schleifenfilterstroms auf den reduzierten Stromwert zum Empfangen einer Empfangsfrequenz nach Abschluss des AF-Tests ausgebildet ist.

Unter Verwendung vorzugsweise eines einzigen Schleifenfilters wird der für schnelle Frequenzwechsel erhöhte Schleifenfilterstrom während des Einschwingvorganges und der Durchführung des AF-Tests beibehalten und nicht wie bislang üblich zu Gunsten eines größeren Verhältnisses des Signal-Rauschabstandes wieder runtergeschaltet. Damit wird die Einschwingzeit der Phasenregel- und Phasenrastschaltung erheblich verkürzt und ein erneutes Einschwingen der Phasenregel- und Phasenrastschaltung nach der herkömmlichen Herunterschaltung des Schleifenfilterstroms oder nach Umschalten auf einen alternativen Schleifenfilter während des AF-Tests vermieden. Mit einer solchermaßen verringerten Einschwingzeit ist z.B. ein zweifacher AF-Test denkbar, der unter der Hörbarkeitsschwelle liegt und somit für das menschliche Ohr nicht oder kaum wahrnehmbar ist.

Der für den Hörgebrauch notwendige große Signal-Rauschabstand wird nach dem AF-Test durch eine Reduktion des Schleifenfilterstroms wiederhergestellt.

Die Störungseinheit ist vorzugsweise zur Umschaltung weitere Parameter des Frequenzgenerators für den AF-Test ausgebildet. Diese umschaltbaren Parameter können beispielsweise die Frequenz des Referenzsignals, die verschiedenen Betriebsmodi, wie Integer- und Fraktional-Betrieb, die einstellbare Fraktionalkompensation, die Frequenzeinstellungen und/oder die Bandbreite des Schleifenfilters sein. Durch eine solche geeignete Wahl der Parameter der Phasenregel- und Phasenrastschaltung während des AF-Tests kann die erforderliche Einschwingzeit des Frequenzgenerators weiter reduziert werden.

Besonders vorteilhaft ist es, wenn an dem Ausgang des spannungsgesteuerten Oszillators ein Teiler angeordnet ist und der Phasenvergleicher mit dem Ausgang des Teilers zum Vergleichen des herabgeteilten Ausgangssignal des spannungsgesteuerten Oszillators mit dem Referenzsignal verbunden ist. Durch einen in an sich bekannter Weise angeordneten Teiler wird die Frequenz für den Phasenvergleicher vorteilhaft reduziert.

Besonders vorteilhaft ist es, wenn das Rückschalten des Schleifenfilterstroms nicht abrupt erfolgt, sondern der Einschwingvorgang nach dem oder den AF-Tests zunächst mit großem Schleifenfilterstrom erfolgt und anschließend der Schleifenfilterstrom allmählich zurückgefahren wird.

Die Erfindung wird nachfolgend anhand der beigefügten Zeichnung näher erläutert. Es zeigt:

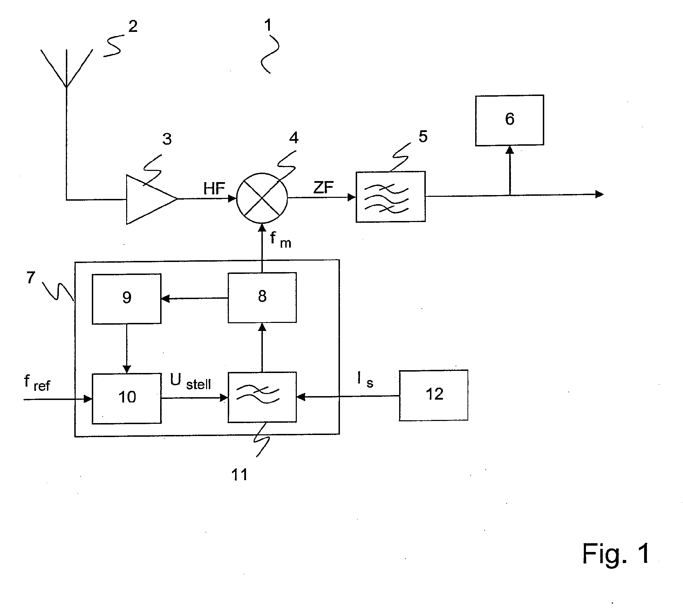

Figur 1: - Blockdiagramm eines Teils einer Rundfunkempfangseinheit mit Frequenzgenerator.

Die Figur 1 lässt ein Blockdiagramm eines Ausschnitts einer Rundfunkempfangseinheit 1 erkennen, bei der ein von einer Antenne 2 empfangenes und mit einem Vorverstärker 3 vorverstärktes hochfrequentes Empfangssignal HF mit einem Mischer 4 in ein Zwischenfrequenzsignal ZF herabgemischt wird. Die Zwischenfrequenz ist bei herkömmlichen Rundfunkempfängern 1 beispielsweise auf 10,7 MHz festgelegt. Es können aber auch mehrere Zwischenfrequenzen vorgesehen werden, wie beispielsweise bei Dreifach-Superempfängern für DRM-Signale (Digital Radio Mondial) mit Zwischenfrequenzen von 10,7 MHz, 455 kHz und 12 kHz.

Das Zwischenfrequenzsignal ZF wird anschließend in einem ZF-Bandbassfilter 5 herausgefiltert und weiterverarbeitet. Hierzu kann an den Ausgang des ZF-Bandbassfilters 5 eine Signalqualitäts-Bewertungseinheit 6 zur Bestimmung der Signalqualität des Empfangssignals auf der eingestellten Frequenz vorgesehen sein.

Zur Einstellung der Empfangsfrequenz ist ein Frequenzgenerator 7 vorgesehen, dessen Ausgang, an dem eine Mischfrequenz fₘ anliegt, an einen Mischer 4 geschaltet ist. Der Frequenzgenerator 7 hat einen spannungsgesteuerten Oszillator 8 (VCO), der auf der Mischfrequenz fₘ schwingt. Der spannungsgesteuerte Oszillator 8 wird in einer Phasenregel- und Phasenrastschaltung PLL angesteuert, d.h. in einer sogenannten phasenstarren Schleife. Hierdurch wird eine Frequenzdifferenz ohne Restfehler ausgeregelt. Der Ausgang des spannungsgesteuerten Oszillators 8 ist hierzu mit einem Teiler 9 verbunden, um die Mischfrequenz fₘ um einen defmierten Faktor N herabzuteilen. Das herabgeteilte Signal fₘ/N wird mit einem Phasenvergleicher 10 mit einem Referenzsignal verglichen, das auf einer stabilen Referenzfrequenz f_{ref} schwingt. Der zweite Ausgang des Oszillators 8 kann direkt mit dem Mischer 4 oder über einen einstellbaren Teiler (nicht dargestellt) mit dem Mischer 4 verbunden sein. Am Ausgang des Phasenvergleichers 10 liegt eine Nachstimmspannung Uₛₜₑₗₗ an, die zur Steuerung eines Schleifenfilters 11 genutzt wird. Das Schleifenfilter 11 ist üblicherweise als Tiefpassfilter ausgeführt, um Oberwellen und eine Selbsterregung zu unterdrücken. Mit dem Schleifenfilter 11 werden Störungen herausgefiltert, die durch den Phasenvergleicher 10 verursacht werden.

Die Einschwingzeit des Frequenzgenerators 7 wird wesentlich durch den Schleifenfilterstrom Iₛ des Schleifenfilters bestimmt. Dieser Schleifenfilterstrom Iₛ wird mit einer Steuerungseinheit 12 eingestellt. Die Steuerungseinheit 12 kann beispielsweise ein programmierbarer Mikroprozessor sein, der über einen Steuerbus eine mit dem Schleifenfilter 11 verbundene (nicht dargestellt) Ladungspumpe ansteuert. Neben dem Schleifenfilterstrom Iₛ kann die Einschwingzeit des Frequenzgenerators 11 zusätzlich auch durch die Referenzfrequenz f_{ref} und die Bandbreite des Schleifenfilters 11 festgelegt werden. Die Frequenz- und Stromeinstellungen des Frequenzgenerators 7 sind üblicherweise über einen digitalen Steuerbus programmierbar.

Die Steuerungseinheit 12 ist so ausgebildet, dass während der Durchführung des AF-Tests der Schleifenfilterstrom Iₛ im Vergleich zu dem Schleifenfilterstrom Iₛ beim Empfang einer Empfangsfrequenz erhöht ist. Vorzugsweise wird der Schleifenfilterstrom Iₛ während des AF-Tests auf den maximalen Stromwert eingestellt. Der Schleifenfilterstrom Iₛ wird während und nach dem Einschwingvorgang des Frequenzgenerators 7 auf die Altemativfiequenz nicht wieder auf einen kleineren Stromwert zurückgeschaltet, sondern auf dem erhöhten Schleifenfilterstrom Iₛ gehalten. Dadurch wird die Einschwingzeit für den AF-Test minimiert. Erst nach dem Rücksprung auf die Ausgangsfrequenz wird der Schleifenfilterstrom Iₛ auf einen kleineren Wert und gegebenenfalls auf die anderen Parameter, wie Referenzfrequenz f_{ref} und Bandbreite des Schleifenfilters wieder auf die ursprüngliche Konfiguration zurückgeschaltet. Bei einem Test von zwei, drei oder mehr Alternativfrequenzen hintereinander wird entsprechend verfahren, so dass beim Umschalten von einer Alternativfrequenz auf die nächste der Schleifenfilterstrom Iₛ auf dem höheren Wert gehalten wird.

Bei der Erhöhung des Schleifenfilterstroms Iₛ verringert sich bei sonst gleichen Randbedingungen das Verhältnis von Signal zu Rauschen (S/N) bei großen Signalen. Diese Reduktion des Signal-Rausch-Verhältnisses (S/N) ist von kurzer Zeitspanne z.B. während der AF-Tests vom menschlichen Ohr nicht wahrnehmbar und stellt damit keine Einschränkung dar. Gleiches gilt für eine entsprechende Umschaltung des Schleifenfilters 11. Für die Erkennung z.B. einer vorliegenden Empfangsfeldstärke bei einer alternativen Frequenz stellt diese Reduktion des Signal-Rausch-Verhältnisses ebenfalls keine Einschränkung dar. Auch ist eine Erkennung von RDS-Information (Radio-Daten-System) mit reduziertem Signal-Rausch-Verhältnis denkbar, wobei die Reduktion jedoch nicht beliebig sein darf.

Der für den Gebrauch notwendige große Signal-Rausch-Abstand S/N wird nach dem AF-Test, d.h. nach dem Rücksprung auf die Ausgangsfrequenz, durch eine Reduktion des Schleifenstroms Iₛ wiederhergestellt.

Vorzugsweise wird der maximale Schleifenstrom Iₛ so eingestellt, dass die Empfindlichkeitsschwelle des Empfängers nicht beeinflusst wird.

## Patentansprüche

1. Rundfunkempfangseinheit (1) mit einem Mischer (4) zum Heruntermischen eines vorfrequenten Empfangssignals (HF) auf eine Zwischenfrequenz (ZF) und mit einem mit dem Mischer (4) verbundenen Frequenzgenerator (7) mit einer Phasenregel- und Phasenrastschaltung, die einen spannungsgesteuerten Oszillator (8), einen mit dem Ausgang des spannungsgesteuerten Oszillators (8) direkt oder indirekt verbundenen Phasenvergleicher (10) zum Vergleichen eines zum Ausgangssignals (fₘ) des spannungsgesteuerten Oszillators (8) proportionalen Signals mit einem Referenzsignal (f_{ref}) und ein Schleifenfilter (11) am Ausgang des Phasenvergleichers (10) hat, wobei der Ausgang des Schleifenfilters (11) mit dem spannungsgesteuerten Oszillator (8) verbunden ist und das Schleifenfilter (11) durch Einstellen eines Schleifenfilterstroms (Iₛ) mit einer Steuerungseinheit (12) einstellbar ist, **dadurch gekennzeichnet, dass** die Steuerungseinheit (12) zur Hochschaltung des Schleifenfilterstroms (Iₛ) auf einen im Vergleich zum eingestellten Stromwert für den Empfang einer Empfangsfrequenz erhöhten Stromwert zur Durchführung eines Tests von alternativen Empfangsfrequenzen (AF-Test) und Beibehaltung des erhöhten Stromwertes während des AF-Tests und Herunterschaltung des Schleifenfilterstroms (Iₛ) auf den reduzierten Stromwert zum Empfangen einer Empfangsfrequenz nach Abschluss des AF-Tests ausgebildet ist.

2. Rundfunkempfangseinheit (1) nach Anspruch 1, **dadurch gekennzeichnet, dass** die Steuerungseinheit (12) zur Umschaltung weiterer Parameter des Frequenzgenerators (7) für den AF-Test ausgebildet ist.

3. Rundfunkempfangseinheit (1) nach Anspruch 2, **dadurch gekennzeichnet, dass** umschaltbare Parameter des Frequenzgenerators (7) die Frequenz des Referenzsignals (f_{ref}) die verschiedenen Betriebsmodi, beispielsweise Integer- und Fraktional-Betrieb, die einstellbare Fraktionalkompensation, die Frequenzeinstellungen und/oder die Bandbreite des Schleifenfilters (11) sind.

4. Rundfunkempfangseinheit (1) nach einem der vorherigen Ansprüche, **gekennzeichnet durch** einen Teiler (9) am Ausgang des spannungsgesteuerten Oszillators (8), wobei der Phasenvergleicher (10) mit dem Teiler (9) verbunden und zum Vergleichen des herabgeteilten Ausgangssignals (fₘ/N) des spannungsgesteuerten Oszillators (8) mit dem Referenzsignal (f_{ref}) vorgesehen ist.

5. Rundfunkempfangseinheit (1) nach einem der vorhergehenden Ansprüche, **dadurch gekennzeichnet, dass** mehrere AF-Tests in Folge mit erhöhtem Schleifenfilterstrom durchgeführt werden.

6. Rundfunkempfangseinheit (1) nach einem der vorhergehenden Ansprüche, **dadurch gekennzeichnet, dass** der Schleifenstrom beim Abschluss des AF-Tests bei gleichbleibender Empfangsfrequenz heruntergeschaltet wird, wenn das Signal für die Empfangsfrequenz als besser bewertet ist.

7. Rundfunkempfangsgerät (1) nach einem der vorhergehenden Ansprüche, **dadurch gekennzeichnet, dass** nach Abschluss des mindestens einen AF-Tests der Einschwingvorgang des Oszillators (8) mit erhöhtem Schleifenfilterstrom erfolgt und anschließend der Schleifenfilterstrom kontinuierlich reduziert wird.
